# EUROPÄISCHE PATENTSCHRIFT

(11) **EP 1 379 849 B1**
(45) Veröffentlichungstag und Bekanntmachung des Hinweises auf die Patenterteilung: **03.09.2008**
(21) Anmeldenummer: 02737881.9
(22) Anmeldetag: 11.03.2002
(51) Int. Cl.: G01L 1/20, G01R 31/28, G01R 31/02

(54) **SCHALTUNGSANORDNUNG MIT MEHREREN SENSORELEMENTEN IN MATRIX-VERSCHALTUNG**
CIRCUIT ARRANGEMENT WITH SEVERAL SENSOR ELEMENTS IN MATRIX CIRCUIT DESIGN
CIRCUIT COMPRENANT PLUSIEURS ELEMENTS DE DETECTION A INTERCONNEXION MATRICIELLE

(30) Priorität: 20.03.2001 LU 90745
(43) Veröffentlichungstag der Anmeldung: 14.01.2004
(73) Patentinhaber: IEE INTERNATIONAL ELECTRONICS & ENGINEERING S.A., 6468 Echternach (LU)
(72) Erfinder: THINNES, Martin, 54311 Trierweiler (DE)
(74) Vertreter: Beissel, Jean
(86) Internationale Anmeldenummer: PCT/EP2002/002648
(87) Internationale Veröffentlichungsnummer: WO 2002/077594

(56) Entgegenhaltungen:
- EP-A- 0 644 053
- EP-A- 0 895 091
- WO-A-01/18515
- DE-U- 20 014 200
- US-A- 5 276 400

## Beschreibung

Die vorliegende Erfindung betrifft eine Schaltungsanordnung mit mehreren Sensorelementen in Matrix-Verschaltung.

Zur Abfrage, d.h. Auslesen von passiven Sensorelementen, wird an das Sensorelement im allgemeinen eine elektrische Testspannung angelegt und der aufgrund der angelegten Spannung fließende Strom gemessen. Auf diese Weise lässt sich der momentane elektrische Zustand des Sensorelements errechnen und daraus die zu messende Größe (Druck, Temperatur etc.) ermitteln. Es ist anzumerken, dass die passiven Sensorelementen beispielsweise einen variablen Widerstand aufweisen können, wie z.B. druckabhängige oder temperaturabhängige Widerstände, oder eine variable Kapazität. Dabei ist klar, dass je nach der zu messenden Eigenschaft des Sensorelements die Testspannung eine Gleichspannung bzw. eine Wechselspannung umfasst.

Eine Sensoreinrichtung mit drucksensiblen Sensoren kann zum Beispiel in einer Sitzbelegungserkennung zur Steuerung eines aktiven Passagierrückhaltesystems in einem Fahrzeug angewandt werden. Eine solche Sensormatte umfaßt mehrere individuelle drucksensible Sensoren, die über die Fläche des Passagiersitzes verteilt in den Sitz integriert sind. Die Sensoren sind an ein Auswertegerät angeschlossen, das den Auslösezusand der einzelnen Sensoren überprüft. Ist der Sitz durch eine Person belegt, werden mehrere der Sensoren aufgrund der durch eine Person auf den Sitz ausgeübten Gewichtskraft ausgelöst, ein Zustand der von der angeschlossenen Auswerteschaltung als Belegungszustand des Sitzes erkannt und an die Airbagsteuerung weitergegeben wird.

Um die Sensoren selektiv abfragen zu können, muss im Prinzip jeder der Sensoren an die Auswerteschaltung angeschlossen werden. Um hierbei die Zahl der Anschlussleitungen zu reduzieren, ist es vorteilhaft die einzelnen Sensoren in einer Matrix-Verschaltung zu betreiben. Dies bedeutet, dass bei einer Anzahl von *n***m* Sensorelementen, im wesentlichen n Zeilenleiter und m Spaltenleiter vorgesehen sind, wobei zwischen jeweils einem Zeilenleiter und einem Spaltenleiter eines der Sensorelemente verschaltet ist. Hierbei ist zu bemerken, dass eine solche Matrix-Verschaltung eine schaltungstechnische Anordnung darstellt. Das heißt, dass eine Matrix-Verschaltung in einer realen Anordnung weder voraussetzt, dass die Sensorelemente in einer regelmäßigen Gitterverteilung angeordnet sein müssen, noch dass die einzelnen Verbindungsleiter geradlinig und parallel bzw. senkrecht zueinander verlaufen müssen.

Zum Auswerten einer Sensoranordnung in Matrix-Verschaltung wird folgendermaßen vorgegangen. Zunächst legt man die gesamte Matrix-Verschaltung mit Ausnahme eines ersten Spaltenleiters auf das gleiche Potential, z.B. auf Masse. An den ersten Spaltenleiter wird nun eine Testspannung angelegt und anschließend selektiv der an den einzelnen Zeilenleitern abfließende Strom gemessen. Auf diese Weise kann man selektiv die Widerstandswerte der zwischen dem ersten Spaltenleiter und den verschiedenen Zeilenleitern verschalteten Sensorelementen ermitteln. Wird diese Vorgehensweise für jeden der Spaltenleiter wiederholt, kann man sämtliche Sensorelemente nacheinander selektiv ausmessen. Es ist hier anzumerken, dass man alternativ die einzelnen Zeilenleiter mit der Testspannung beaufschlagen und den über die Sensorelemente abfließenden Strom an den Spaltenleitern messen kann um die einzelnen Sensorelemente abzufragen.

Wird eine derartigen Schaltungsanordnung mit Sensorelementen in sicherheitsrelevanten Bereichen eingesetzt, wie z.B. bei der oben beschriebenen Airbagsteuerung in einem Fahrzeug, ist es unerlässlich, eine Fehlfunktion der Schaltungsanordnung aufgrund eines Leiterdefektes zu erkennen und gegebenenfalls kompensieren zu können. Bei einer einfachen Matrix-Verschaltung führt ein Leiterbruch beispielsweise dazu, dass alle hinter den Leiterbruch liegenden Sensorelemente (von der Auswerteschaltung gesehen) nicht mehr auslesbar sind. Wird der Leiterbruch nicht von der Auswerteschaltung erkannt, wird bei einem solchen Defekt darauf geschlossen, dass die entsprechenden Sensorelemente nicht ausgelöst sind und folglich die eigentliche Sitzbelegungssituation falsch interpretiert. Es müssen folglich geeignete Mittel vorgesehen werden, die es ermöglichen, das Auftreten eines Defekts zumindest zu erkennen.

Zu diesem Zweck wird in der EP-A-0 895 091_{[JBL1]} eine Schaltungsanordnung vorgeschlagen, bei der neben den n Zeilenleitern und den m Spaltenleitern jeweils ein zusätzlicher Zeilenleiter und ein zusätzlicher Spaltenleiter vorgesehen sind. Die freien Enden der m Spaltenleiter sind dabei jeweils über einen Überwachungswiderstand mit dem zusätzlichen Zeilenleiter verbunden und die freien Enden der n Zeilenleiter sind jeweils über einen Überwachungswiderstand mit dem zusätzlichen Spaltenleiter verbunden. Nach dem selektiven Auslesen der n*m Sensorelemente werden die Überwachungswiderstände zwischen den einzelnen Spaltenleitern und dem zusätzlichen Zeilenleiter bzw. zwischen den einzelnen Zeilenleitern und dem zusätzlichen Spaltenleiter ausgelesen. Kann einer der Überwachungswiderstände nicht ausgelesen werden, kann das Messsystem darauf schließen, dass ein Leiterbruch in dem zu dem Überwachungswiderstand führenden Zeilenleiter bzw. Spaltenleiter vorliegt. Die entsprechende Zeile bzw. Spalte kann daraufhin von der Auswerteschaltung deaktiviert werden, so dass eine falsche Interpretation der Sitzbelegungssituation verhindert wird.

Nachteilig an dieser Vorrichtung ist, dass beim Erkennen eines Leiterbruchs die gesamte von diesem Leiter betroffene Spalte bzw. Zeile deaktiviert werden muss und somit zur eigentlichen Situationserkennung nicht mehr zur Verfügung steht. Hierdurch verschlechtert sich jedoch das Auflösungsvermögen der Sensoreinrichtung.

### Aufgabe der Erfindung

Aufgabe der vorliegenden Erfindung ist es folglich, eine gattungsgemäße Schaltungsanordnung vorzuschlagen, mit der ein Defekt in einer Leiterbahn möglichst kompensiert werden kann.

### Allgemeine Beschreibung der Erfindung

Diese Aufgabe wird erfindungsgemäß gelöst durch eine Schaltungsanordnung mit *i* Sensorelemente, die in einer schaltungstechnischen (*n* x *m*)-Matrix-Verschaltung mit *n* Zeilenleitern und *m* Spaltenleitern verschaltet sind, wobei *i*, *n* und *m* natürliche Zahlen verschieden von Null sind und wobei 1≤*i*≤*n*m*, wobei ein erstes Leiterende der *n* Zeilenleiter und *m* Spaltenleiter an eine Auswerteschaltung anschließbar ist und wobei jedes der *i* Sensorelemente zwischen jeweils zwei Leitern der Zeilenleiter und Spaltenleiter verschaltet ist. Erfindungsgemäß umfasst die Anordnung weiterhin mindestens einen Rückleiter, dessen erstes Leiterende an die Auswerteschaltung anschließbar ist und dessen zweites Leiterende mit dem zweiten Leiterende eines der Zeilen- bzw. Spaltenleiter kontaktiert ist. Darüber hinaus sind das erste Leiterende des Rückleiters und das erste Leiterende des kontaktierten Zeilen- bzw. Spaltenleiters von der Auswerteschaltung getrennt ansteuerbar d.h. jedes der ersten Leiterenden des Zeilen- bzw. Spaltenleiters und des Rückleiters sind getrennt an die Ansteuervorrichtung anschließbar, so dass im Betrieb das erste Leiterende des Rückleiters und das erste Leiterende des kontaktierten Zeilen- bzw. Spaltenleiters von der Auswerteschaltung getrennt angesteuert werden.

Bei der erfindungsgemäße Schaltungsanordnung ist demnach mindestens einer der Zeilen- bzw. Spaltenleiter zu der anzuschließenden Auswerteschaltung zurückgeführt. Kommt es bei dem zurückgeführten Zeilen- bzw. Spaltenleiter zu einem Leitungsbruch, können die vor der Unterbrechung der Leitung kontaktierten Sensorelemente durch den eigentlichen Zeilen- bzw. Spaltenleiter ausgelesen werden, während die (von der Auswerteschaltung aus gesehen) hinter der Unterbrechung kontaktierten Sensorelemente über den Rückleiter ausgelesen werden können. Auf diese Weise bleiben nach einer Leitungsunterbrechung alle an dem jeweiligen Leiter angeschlossenen Sensorelemente weiterhin ansprechbar und stehen somit der eigentlichen Situationsbestimmung weiterhin zur Verfügung.

Es ist anzumerken, dass in einer vorteilhaften Ausgestaltung der Schaltungsanordnung alle vorhandenen Zeilen- bzw. Spaltenleiter mittels zugeordneter Rückleitungen zu der Auswerteschaltung zurückgeführt sein können. Je nach Einsatz der Schaltungsanordnung kann es jedoch erforderlich sein, lediglich einzelne Zeilen- bzw. Spaltenleiter oder aber einzelne Gruppen dieser Leiter zurückzuführen. Es ist weiterhin anzumerken, dass die Erfindung sich sowohl auf Schaltungsanordnungen bezieht, bei denen alle Sensorelemente zwischen jeweils einem Zeilenleiter und einem Spaltenleiter verschaltet sind, als auch auf Schaltungsanordnungen, bei denen einige der Sensorelemente jeweils zwischen zwei Spaltenleiter bzw. zwischen zwei Zeilenelemente verschaltet sind. Eine derartige Anordnung ist beispielsweise in der LU-A-90 437 _{[JBL2]}beschrieben.

In einer Variante der Erfindung können das erste Leiterende des Rückleiters und das erste Leiterende des kontaktierten Zeilen- bzw. Spaltenleiters von der Auswerteschaltung zusätzlich parallel ansteuerbar sein. Bei dieser Ausgestaltung können nach alle an den jeweiligen Zeilen- bzw. Spaltenleiter angeschlossenen Sensorelemente ausgelesen werden, ohne dass ein eventueller Leiterbruch detektiert wird.

Wie oben bereits beschrieben sind bei der vorliegenden Erfindung das erste Leiterende des Rückleiters und das erste Leiterende des kontaktierten Zeilen- bzw. Spaltenleiters von der Auswerteschaltung getrennt ansteuerbar, d.h. jedes der ersten Leiterenden des Zeilen- bzw. Spaltenleiters und des Rückleiters sind getrennt an die Ansteuervorrichtung anschließbar. Bei einer solchen Ausgestaltung kann beispielsweise eine Ansteuerung des Rückleiters nur dann erfolgen, wenn eines der an den rückgeführten Zeilen- bzw. Spaltenleiter angeschlossene Sensorelement bei der eigentlichen Abfrage kein Signal erzeugt. Wird das betroffene Sensorelement anschließend über den Rückleiter abgefragt und erhält die Auswerteschaltung hierbei ein einem Schaltzustand entsprechendes Signal, kann eindeutig auf das Vorhandensein einer Leiterbahnunterbrechung geschlossen werden. Dieser Zustand kann beispielsweise von der Auswerteschaltung in einem Fehlerspeicher gespeichert und, im Falle eines Sitzbelegungssensors für ein Fahrzeug, gegebenenfalls über ein Warnlicht dem Fahrer angezeigt werden. Wird bei der Abfrage des betreffenden Sensorelementes über den Rückleiter kein Signal gemessen, ist das Sensorelement entweder nicht ausgelöst, defekt oder beide Leitungen weisen einen Leitungsbruch aus. In diesem Fall kann demnach keine eindeutige Aussage über den Zustand der Schaltungsanordnung getroffen werden

In einer besonders vorteilhaften Ausgestaltung der Erfindung weist die Schaltungsanordnung daher einen zusätzlichen Zeilenleiter auf, wobei das zweite Leiterende von mindestens einem Spaltenleiter, vorzugsweise von allen Spaltenleitern, mit dem zusätzlichen Zeilenleiter kontaktiert sind. Die Kontaktierung kann dabei beispielsweise mittels eines Widerstandselements erfolgen. Diese Ausgestaltung ermöglicht es, sowohl den rückgeführten Spaltenleiter als auch den zugeordneten Rückleiter zu überprüfen, indem der jeweilige Widerstand zu dem zusätzlichen Zeilenleiter überprüft wird. Hierdurch lässt sich eindeutig feststellen, ob und gegebenenfalls in welchen Leiter ein Leitungsbruch aufgetreten ist.

Um im Fall eines Leitungsbruchs des zusätzlichen Zeilenleiters, die Überwachungsfunktion der Anordnung zu gewährleisten, weist die Anordnung vorzugsweise einen Rückleiter auf, dessen erstes Leiterende an die Auswerteschaltung anschließbar ist und dessen zweites Leiterende mit dem zweiten Leiterende des zusätzlichen Zeilenleiters kontaktiert ist.

Analog zu dem zusätzlichen Zeilenleiter, kann die Schaltungsanordnung auch einen zusätzlichen Spaltenleiter aufweisen, wobei das zweite Leiterende von mindestens einem Zeilenleiter mit dem zusätzlichen Spaltenleiter kontaktiert sind. Auch hier erfolgt die Kontaktierung beispielsweise mittels eines Widerstandselements und es ist vorteilhaft ein Rückleiter vorgesehen, dessen erstes Leiterende an die Auswerteschaltung anschließbar ist und dessen zweites Leiterende mit dem zweiten Leiterende des zusätzlichen Spaltenleiters kontaktiert ist..

### Beschreibung anhand der Figuren

Im folgenden wird eine Ausgestaltung der Erfindung anhand der beiliegenden Figuren beschrieben. Es zeigen:
- Fig.1:: eine erste Ausgestaltung einer erfindungsgemäßen Schaltungsanordnung, wobei jeder Zeilenleiter und jeder Spaltenleiter rückgeführt ist,
- Fig.2:: eine Ausgestaltung der Erfindung mit Überwachungswiderständen.

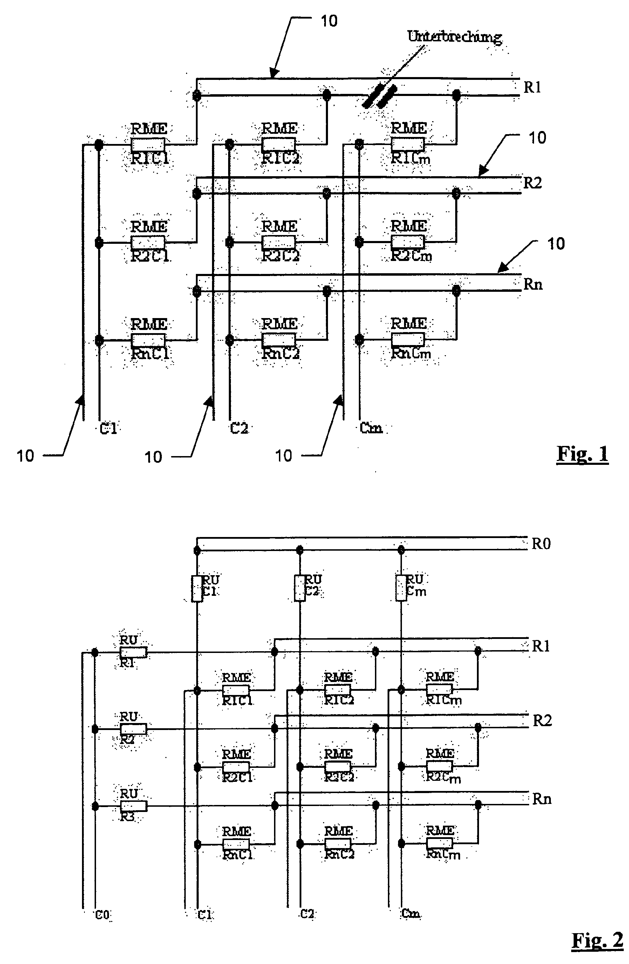

Eine erste Ausgestaltung der erfindungsgemäßen Schaltungsanordnung ist in Fig. 1 dargestellt. Die Schaltungsanordnung umfasst eine Vielzahl von Zeilenleitern R1, R2, ..., Rn sowie eine Vielzahl von Spaltenleitern C1, C2, ..., Cm, zwischen denen jeweils ein Sensorelement RME verschaltet ist. Jedem der Zeilen- bzw. Spaltenleiter ist ein Rückleiter zugeordnet, mit dem der jeweilige Leiter zu einer nicht dargestellten Auswerteschaltung zurückgeführt wird.

Mit dieser Schaltungsanordnung ist es möglich Sensorelemente RME auch dann noch abzufragen, wenn eine Leiterbahn durchbrochen ist. In Fig.1 ist der Zeilenleiter R1 unterbrochen. Die Unterbrechung liegt dabei zwischen den Kontaktierungspunkten des Zeilenleiters R1 mit den Spaltenleitern C2 und Cm. Bei einer herkömmlichen Schaltungsanordnung bewirkt eine derartige Unterbrechung einer Leiterbahn, dass die Sensorelemente R1C1 und R1C2 nicht mehr abgefragt werden können. Bei der dargestellten Ausgestaltung ist dies nicht der Fall, da die beiden betreffenden Sensorelemente über die dem Zeilenleiter R1 zugeordnete Rückleitung 10 abgefragt werden können.

Eine besonders vorteilhafte Ausgestaltung der Erfindung ist in Fig. 2 dargestellt. Diese zeigt eine Schaltungsanordnung bei der zusätzlich Überwachungswiderstände RU jeweils zwischen den Spaltenleitern C1, C2, ..., Cm und einem zusätzlichen Zeilenleiter R0, bzw. zwischen den Zeilenleitern R1, R2, ..., Rn und einem zusätzlichen Spaltenleiter C0 verschaltet sind.

Diese Ausgestaltung ermöglicht es, sowohl einen rückgeführten Spalten- bzw. Zeilenleiter als auch den zugeordneten Rückleiter zu überprüfen, indem der jeweilige Widerstand zu dem zusätzlichen Zeilen- bzw. Spaltenleiter überprüft wird. Hierdurch lässt sich eindeutig feststellen, ob und gegebenenfalls in welchen Leiter ein Leitungsbruch aufgetreten ist.

## Patentansprüche

1. Schaltungsanordnung umfassend *i* Sensorelemente (RME) und eine Auswerteschaltung, wobei die *i* Sensorelemente (RME) in einer schaltungstechnischen (nxm)-Matrix-Verschaltung mit n Zeilenleitern (R1, R2, ..., Rn) und *m* Spaltenleitern (C1, C2, ..., Cm) verschaltet sind, wobei *i, n* und *m* natürliche Zahlen verschieden von Null sind und wobei 1 ≤ *i* ≤ *n*m*, wobei ein erstes Leiterende der n Zeilenleiter (R1, R2, ..., Rn) und m Spaltenleiter (C1, C2, ..., Cm) an die Auswerteschaltung angeschlossen ist, wobei jedes der *i* Sensorelemente (RME) zwischen jeweils einem der Zeilenleiter (R1, R2, ..., Rn) und einem der Spaltenleiter (C1, C2, ..., Cm) verschaltet ist und wobei mindestens ein Rückleiter vorhanden ist, dessen erstes Leiterende im Betrieb an die Auswerteschaltung angeschlossen ist und dessen zweites Leiterende mit dem zweiten Leiterende eines der Zeilen- bzw. Spaltenleiter (R1, R2, ..., Rn; C1, C2, ..., Cm) kontaktiert ist, **dadurch gekennzeichnet, dass** im Betrieb das erste Leiterende des kontaktierten Zeilen- bzw. Spaltenleiters (R1, R2, ..., Rn; C1, C2, ..., Cm) und das erste Leiterende des Rückleiters von der Auswerteschaltung nacheinander getrennt angesteuert werden.

2. Schaltungsanordnung nach Anspruch 1 , **gekennzeichnet durch** einen zusätzlichen Zeilenleiter (R0), wobei das zweite Leiterende von mindestens einem Spaltenleiter (C1, C2, ..., Cm) mit dem zusätzlichen Zeilenleiter (R0) kontaktiert sind.

3. Schaltungsanordnung nach Anspruch 2, **dadurch gekennzeichnet, dass** die Kontaktierung mittels eines Widerstandselements (RU) erfolgt.

4. Schaltungsanordnung nach einem der Ansprüche 2 oder 3, **gekennzeichnet durch** einen Rückleiter, dessen erstes Leiterende an die Auswerteschaltung anschließbar ist und dessen zweites Leiterende mit dem zweiten Leiterende des zusätzlichen Zeilenleiters (R0) kontaktiert ist.

5. Schaltungsanordnung nach einem der Ansprüche 1 bis 4, **gekennzeichnet durch** einen zusätzlichen Spaltenleiter (C0), wobei das zweite Leiterende von mindestens einem Zeilenleiter (R1, R2, ..., Rn) mit dem zusätzlichen Spaltenleiter (C0) kontaktiert sind.

6. Schaltungsanordnung nach Anspruch 5, **dadurch gekennzeichnet, dass** die Kontaktierung mittels eines Widerstandselements (RU) erfolgt.

7. Schaltungsanordnung nach einem der Ansprüche 5 oder 6, **gekennzeichnet durch** einen Rückleiter, dessen erstes Leiterende an die Auswerteschaltung anschließbar ist und dessen zweites Leiterende mit dem zweiten Leiterende des zusätzlichen Spaltenleiters (C0) kontaktiert ist.

## Claims

1. A circuit arrangement comprising *i* sensor elements (RME) and an evaluation circuit, said *i* sensor elements (RME) being interconnected in an (*n x m*) matrix circuit configuration with *n* row conductors (R1, R2, ..., Rn) and *m* column conductors (C1, C2, ..., Cm), where *i*, *n* and *m* are natural numbers different from zero and where 1 ≤ *i* ≤ *n***m,* wherein a first conductor end of the *n* row conductors (R1, R2, . , Rn) and *m* column conductors (C1, C2, ..., Cm) are connected to the evaluation circuit, wherein each of the *i* sensor elements (RME) is connected between one of the conductors from the row conductors (R1, R2, .., Rn) and one of the column conductors (C1, C2, ..., Cm), and wherein at least one return conductor is provided for, whose first conductor end is connected, in operation, to the evaluation circuit and whose second conductor end is in contact with the second conductor end of one of the row or column conductors (R1, R2, .., Rn; C1, C2, ..., Cm), **characterized in that,** in operation, the first conductor end of the contacted row or column conductor (R1, R2, . , Rn; C1, C2, ..., Cm) and the first conductor end of the return conductor are actuated separately one after the other by the evaluation circuit

2. The circuit arrangement as claimed in claim 1, **characterized by** an additional row conductor (R0), wherein the second conductor end of at least one column conductor (C1, C2, Cm) is in contact with the additional row conductor (R0)

3. The circuit arrangement as claimed in claim 2, **characterized in that** the contact is made by means of a resistor element (RU).

4. The circuit arrangement as claimed in one of claims 2 or 3, **characterized by** a return conductor whose first conductor end can be connected to the evaluation circuit and whose second conductor end is in contact with the second conductor end of the additional row conductor (R0).

5. The circuit arrangement as claimed in one of claims 1 to 4, **characterized by** an additional column conductor (CO), with the second conductor end of at least one row conductor (R1, R2, ..., Rn) being in contact with the additional column conductor (C0).

6. The circuit arrangement as claimed in claim 5, **characterized in that** the contact is made by means of a resistor element (RU)

7. The circuit arrangement as claimed in one of claims 5 or 6, **characterized by** a return conductor whose first conductor end can be connected to the evaluation circuit and whose second conductor end is in contact with the second conductor end of the additional column conductor (C0).

## Revendications

1. Agencement de circuit comprenant i éléments de détection (RME) et un circuit d'évaluation, les i éléments de détection (RME) étant interconnectés dans une interconnexion matricielle (n x m) de commutation avec n conducteurs de ligne (R1, R2, ..., Rn) et m conducteurs de colonne (C1, C2, ..., Cm), i, n et m étant des entiers naturels différents de zéro et sachant que 1 ≤ i ≤n * m, une première extrémité des n conducteurs de ligne (R1, R2, , Rn) et m conducteurs de colonne (C1, C2, ..., Cm) étant raccordés au circuit d'évaluation, chacun des i éléments de détection (RME) étant connecté entre respectivement l'un des conducteurs de ligne (R1, R2, ..., Rn) et l'un des conducteurs de colonne (C1, C2, , Cm) et au moins un conducteur de retour étant présent, dont la première extrémité de conducteur est raccordée pendant le service au circuit d'évaluation et dont la seconde extrémité de conducteur est mise en contact avec la seconde extrémité de conducteur de l'un des conducteurs de ligne ou de colonne (R1, R2, ..., Rn ; C1, C2, ..., Cm), **caractérisé en ce que**, pendant le service, la première extrémité de conducteur du conducteur de ligne ou de colonne (R1, R2, ..., Rn); C1, C2, , Cm) mis en contact et la première extrémité de conducteur du conducteur de retour sont activées séparément et de façon consécutive par le circuit d'évaluation

2. Agencement de circuit selon la revendication 1, **caractérisé par** un conducteur de ligne (R0) supplémentaire, la seconde extrémité du conducteur étant mise en contact par au moins un conducteur de colonne (C1, C2, ..., Cm) avec le conducteur de ligne (R0) supplémentaire.

3. Agencement de circuit selon la revendication 2, **caractérisé en ce que** la mise en contact s'effectue au moyen d'un élément de résistance (RU)

4. Agencement de circuit selon l'une quelconque des revendications 2 ou 3, **caractérisé par** un conducteur de retour, dont la première extrémité peut être raccordée au circuit d'évaluation et dont la seconde extrémité est mise en contact avec la seconde extrémité du conducteur de ligne (R0) supplémentaire

5. Agencement de circuit selon l'une quelconque des revendications 1 à 4, **caractérisé par** un conducteur de colonne (C0) supplémentaire, la seconde extrémité du conducteur étant mise en contact par au moins un conducteur de ligne (R1, R2, , Rn) avec le conducteur de colonne (C0) supplémentaire

6. Agencement de circuit selon la revendication 5, **caractérisé en ce que** la mise en contact s'effectue au moyen d'un élément de résistance (RU).

7. Agencement de circuit selon l'une quelconque des revendications 5 ou 6, **caractérisé par** un conducteur de retour, dont la première extrémité peut être raccordée au circuit d'évaluation et dont la seconde extrémité est mise en contact avec la seconde extrémité du conducteur de colonne (C0) supplémentaire
